# EUROPEAN PATENT SPECIFICATION

(11) **EP 4 287 795 B1**
(45) Date of publication and mention of the grant of the patent: **18.02.2026**
(21) Application number: 22763572.9
(22) Date of filing: 02.03.2022
(51) Int. Cl.: H04M 1/02, H04M 1/18

(54) **ELECTRONIC DEVICE COMPRISING WATERPROOF STRUCTURE**
ELEKTRONISCHE VORRICHTUNG MIT WASSERDICHTER STRUKTUR
DISPOSITIF ÉLECTRONIQUE COMPRENANT UNE STRUCTURE ÉTANCHE À L'EAU

(30) Priority: 04.03.2021 KR 20210029042
(43) Date of publication of application: 06.12.2023
(73) Proprietor: Samsung Electronics Co., Ltd., Suwon-si, Gyeonggi-do 16677 (KR)
(72) Inventor: CHO, Woosik, Suwon-si, Gyeonggi-do 16677 (KR); KIM, Hojong, Suwon-si, Gyeonggi-do 16677 (KR); HUH, Jaeyoung, Suwon-si, Gyeonggi-do 16677 (KR)
(74) Representative: Appleyard Lees IP LLP
(86) International application number: PCT/KR2022/002915
(87) International publication number: WO 2022/186590

(56) References cited:
- KR-A- 20170 053 401
- KR-A- 20190 011 169
- KR-A- 20190 054 384
- KR-A- 20200 101 178
- US-A1- 2012 176 754
- US-A1- 2018 183 912

## Description

### Technical Field

Various embodiments of this document relate to an electronic device that comprises a waterproof structure.

### Background Art

As design has emerged as a differentiating factor because of the upward leveling of specifications of electronic devices such as smartphones, there is a trend to implement exterior members (e.g., housings) to have a visually luxurious texture. The electronic device may include a metal appearance member, which can not only provide a luxurious design unique to metal but also improve durability. As the range of applications available to electronic devices such as smartphones expands, the number of antennas included in electronic devices is constantly increasing. The electronic device may utilize a metal appearance member as at least a portion of the antenna (e.g., an emitter). US 2018/0183912 A1 describes an electronic device having an electronic component mounting structure through a bending area of a bended display.

### Disclosure of Invention

### Technical Problem

The electronic device may include an electrical path, such as a flexible printed circuit board, that electrically connects a metal exterior member utilized as an antenna with a wireless communication circuit. Because of the electricity flow structure between the metal exterior member and the electrical path used as an antenna, it may be difficult to secure an area for placing the adhesive member for waterproofing between the exterior members.

Various embodiments of the present document may provide an electronic device including a waterproof structure for securing an area for disposing an adhesive member for waterproofing in connection with an electricity flow structure with respect to the housing.

Technical problems to be solved in the present document are not limited to the aforementioned technical problems, and other technical problems not described above may be easily understood from the following description by a person having ordinary knowledge in the art to which the disclosure pertains.

### Solution to Problem

According to the invention as defined in independent claim 1, an electronic device comprises: a housing including a front plate, a rear plate, and a side bezel structure which at least partially surrounds a space between the front plate and the rear plate and comprises a conductive portion; a support structure that is connected to the side bezel structure or is formed integrally with the side bezel structure, and is located in the space; and a conductor which includes a first portion extending into the support structure and a second portion extending from the first portion into the space; a first adhesive member located between the support structure and the front plate along the side bezel structure; and a second adhesive member located between the support structure and the rear plate along the side bezel structure, wherein a portion of the support structure may be located between the second adhesive member and the first portion. The support structure comprises a conductive area which is connected to or integrally formed with the conductive portion of the side bezel structure, and an opening located between the conductive area and the rear plate. The first portion of the conductor and the conductive area of the support structure are electronically connected at a position overlapping the opening such that the first portion is electrically connected to the conductive portion of the side bezel structure through the conductive area of the support structure.

Further advantageous features are defined in the dependent claims.

### Advantageous Effects of Invention

Electronic devices including waterproof structures according to various embodiments of the present document may secure waterproofing functions by implementing an electricity flow structure with respect to the housing to secure an area for disposing adhesive members for waterproofing.

In addition, effects that may be obtained or predicted by various embodiments of this document may be disclosed directly or implicitly in the detailed description of the embodiments herein.

### Brief Description of Drawings

FIG. 1 is a block diagram of an electronic device in a network environment according to an embodiment.
FIG. 2 is a perspective view of the front surface of an electronic device according to an embodiment.
FIG. 3 is a perspective view of the rear surface of the electronic device of FIG. 2 according to an embodiment.
FIG. 4 is an exploded perspective view of the electronic device of FIG. 2 according to an embodiment.
FIG. 5, in an embodiment, illustrates a cross-sectional structure of the y-z plane with respect to the A-A' line in FIG. 3.
FIG. 6, in an embodiment, is a plan view of the front case of FIG. 4 when viewed in the +z axis direction.
FIG. 7, in an embodiment, illustrates a side bezel structure, a support structure, a first electrical path, a second electrical path, or a bolt in connection with the example of FIG. 5.
FIG. 8, in another embodiment, illustrates a cross-sectional structure of the y-z plane with respect to the A-A' line in FIG. 3.
FIG. 9, in another embodiment, illustrates a cross-sectional structure of the y-z plane with respect to the A-A' line in FIG. 3.
FIG. 10, for example, in connection with the example of FIG. 9, illustrates a side bezel structure, a support structure, a first electrical path, a second electrical path, or a cover member.
FIG. 11, in another embodiment, illustrates the cross-sectional structure of the y-z plane with respect to the A-A' line in FIG. 3.
FIG. 12, in another embodiment, illustrates a cross-sectional structure of the y-z plane with respect to the A-A' line in FIG. 3.

### Mode for the Invention

Hereinafter, various embodiments of the disclosure disclosed herein will be described with reference to the accompanying drawings.

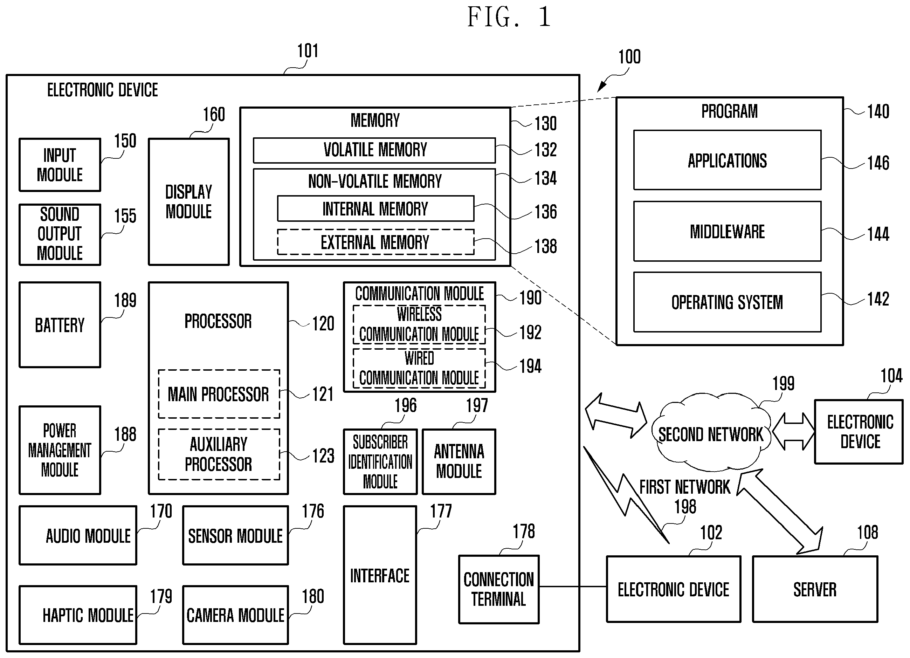

FIG. 1 is a block diagram of an electronic device 101 in a network environment 100 according to an embodiment.

With reference to FIG. 1, the electronic device 101 in the network environment 100 may communicate with an external electronic device 102 via a first network 198 (e.g., a short-range wireless communication network), or at least one of an external electronic device 104 or a server 108 via a second network 199 (e.g., a long-range wireless communication network). The electronic device 101 may communicate with the external electronic device 104 via the server 108. The electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, and/or an antenna module 197. In some embodiments of the disclosure, at least one (e.g., the connection terminal 178) of the components may be omitted from the electronic device 101, or one or more other components may be added in the electronic device 101. In some embodiments of the disclosure, some of the components may be implemented as single integrated circuitry. For example, the sensor module 176, the camera module 180, or the antenna module 197 may be implemented as embedded in single component (e.g., the display module 160).

The processor 120 may execute, for example, software (e.g., a program 140) to control at least one other component (e.g., a hardware or software component) of the electronic device 101 coupled with the processor 120, and may perform various data processing or computation. As at least part of the data processing or computation, the processor 120 may load a command or data received from another component (e.g., the sensor module 176 or the communication module 190) in a volatile memory 132, process the command or the data stored in the volatile memory 132, and store resulting data in a non-volatile memory 134. The processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., a sleep) state, or together with the main processor 121 while the main processor 121 is in an active state (e.g., executing an application). The auxiliary processor 123 (e.g., an ISP or a CP) may be implemented as part of another component (e.g., the camera module 180 or the communication module 190) functionally related to the auxiliary processor 123. According to an embodiment of the disclosure, the auxiliary processor 123 (e.g., a neural network processing device) may include a hardware structure specified for processing an artificial intelligence model. The artificial intelligence model may be created through machine learning. Such learning may be performed, for example, in the electronic device 101 itself on which the artificial intelligence model is performed, or may be performed through a separate server (e.g., the server 108). The learning algorithms may include, for example, supervised learning, unsupervised learning, semi-supervised learning, or reinforcement learning, but is not limited thereto. The artificial intelligence model may include a plurality of artificial neural network layers. The artificial neural network may be any of a deep neural network (DNN), a convolutional neural network (CNN), a recurrent neural network (RNN), a restricted Boltzmann machine (RBM), a deep belief network (DBN), a bidirectional recurrent DNN (BRDNN), a deep Q-network, or a combination of two or more of the above-mentioned networks, but is not limited the above-mentioned examples. In addition to the hardware structure, the artificial intelligence model may additionally or alternatively include a software structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 and/or the non-volatile memory 134.

The program 140 may be stored in the memory 130 as software, and may include, for example, an operating system (OS) 142, middleware 144, and/or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record, and the receiver may be used for incoming calls. The receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. The display module 160 may include touch circuitry (e.g., a touch sensor) adapted to detect a touch, or sensor circuitry (e.g., a pressure sensor) adapted to measure the intensity of force incurred by the touch.

The audio module 170 may convert a sound into an electrical signal and vice versa. The audio module 170 may obtain the sound via the input module 150, or output the sound via the sound output module 155 or a headphone of an external electronic device (e.g., the external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. The interface 177 may include, for example, a high-definition multimedia interface (HDMI), a universal serial bus (USB) interface, a secure digital (SD) card interface, and/or an audio interface.

The connecting terminal 178 may include a connector via which the electronic device 101 may be physically connected with the external electronic device (e.g., the external electronic device 102). The connecting terminal 178 may include, for example, an HDMI connector, a USB connector, an SD card connector, and/or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, ISPs, or flashes.

The power management module 188 may manage power supplied to or consumed by the electronic device 101. The power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more CPs that are operable independently from the processor 120 (e.g., the AP) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BLUETOOTH, wireless-fidelity (Wi-Fi) direct, or IR data association (IrDA)) or the second network 199 (e.g., a long-range communication network, such as a legacy cellular network, a 5th generation (5G) network, a next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4th generation (4G) network, and next-generation communication technology, e.g., new radio (NR) access technology. The NR access technology may support high-speed transmission of high-capacity data (i.e., enhanced mobile broadband (eMBB)), minimization of terminal power and connection of multiple terminals (massive machine type communications (mMTC)), or high reliability and low latency (ultra-reliable and low-latency communications (URLLC)). The wireless communication module 192 may support a high-frequency band (e.g., a mmWave band) to achieve, for example, a high data transmission rate. The wireless communication module 192 may support various technologies for securing performance in a high-frequency band, such as beamforming, massive multiple-input and multiple-output (MIMO), full-dimensional MIMO (FD-MIMO), array antenna, analog beam-forming, or large-scale antenna. The wireless communication module 192 may support various requirements specified in the electronic device 101, an external electronic device (e.g., external the electronic device 104), or a network system (e.g., the second network 199). According to an embodiment of the disclosure, the wireless communication module 192 may support a peak data rate for implementing eMBB (e.g., 20Gbps or more), loss coverage for implementing mMTC (e.g., 164dB or less), or U-plane latency for realizing URLLC (e.g., 0.5ms or less for each of downlink (DL) and uplink (UL) or 1ms or less for round trip).

The antenna module 197 may transmit or receive a signal or power to or from the outside (e.g., the external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., an antenna array). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. Another component (e.g., a radio frequency integrated circuit (RFIC)) other than the radiating element may be additionally formed as part of the antenna module 197.

According to various embodiments of the disclosure, the antenna module 197 may form a mmWave antenna module. According to an embodiment of the disclosure, the mmWave antenna module may include a PCB, an RFIC that is disposed on or adjacent to a first surface (e.g., the bottom surface) of the PCB and is capable of supporting a predetermined high-frequency band (e.g., a mmWave band), and a plurality of antennas (e.g., array antennas) that is disposed on or adjacent to a second surface (e.g., the top surface or the side surface) of the PCB and is capable of transmitting or receiving a signal of the predetermined high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

Commands or data may be transmitted or received between the electronic device 101 and the external electronic device 104 via the server 108 coupled with the second network 199. Each of the external electronic devices 102 or 104 may be a device of a same type as, or a different type, from the electronic device 101. All or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide an ultra-low delay service using, for example, distributed computing or MEC. In another embodiment of the disclosure, the external electronic device 104 may include an internet of things (loT) device. The server 108 may be an intelligent server using machine learning and/or neural networks. According to an embodiment of the disclosure, the external electronic device 104 or the server 108 may be included in the second network 199. The electronic device 101 may be applied to an intelligent service (e.g., smart home, smart city, smart car, or healthcare) based on 5G communication technology or loT-related technology.

An electronic device according to an embodiment of the disclosure may be one of various types of electronic devices. The electronic devices may include a portable communication device (e.g., a smartphone), a computer device, a portable multimedia device, a portable medical device, a camera, a wearable device, or a home appliance. However, the electronic device is not limited to any of those described above.

Various embodiments of the disclosure and the terms used herein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively," as "coupled with," "coupled to," "connected with," or "connected to" another element (e.g., a second element), it means that the element may be coupled with the other element directly (e.g., wiredly), wirelessly, or via a third element.

The term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment of the disclosure, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

A method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PLAYSTORETM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Each component (e.g., a module or a program) of the above-described components may include a single entity or multiple entities. One or more of the above-described components may be omitted, or one or more other components may be added. Alternatively or additionally, a plurality of components (e.g., modules or programs) may be integrated into a single component. In such a case, the integrated component may perform one or more functions of each of the plurality of components in the same or similar manner as they are performed by a corresponding one of the plurality of components before the integration. Operations performed by the module, the program, or another component may be carried out sequentially, in parallel, repeatedly, or heuristically, or one or more of the operations may be executed in a different order or omitted, or one or more other operations may be added.

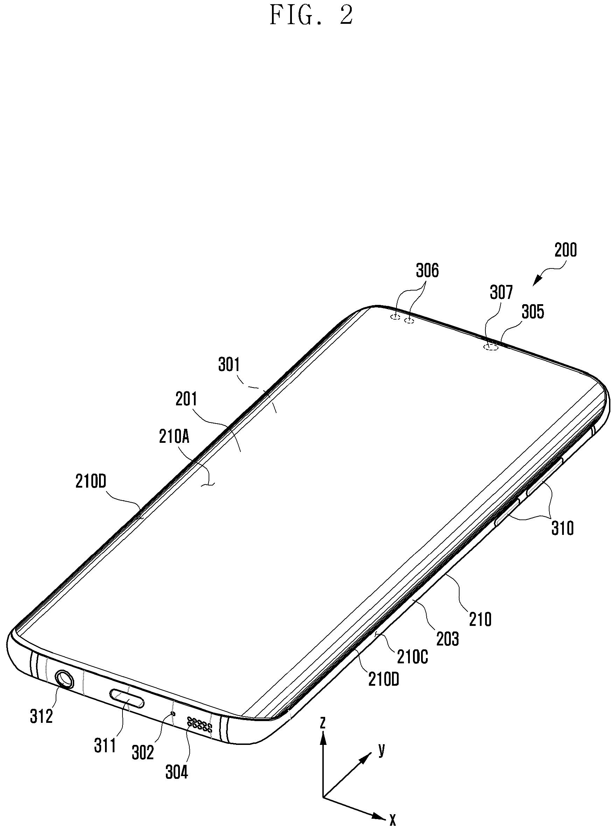

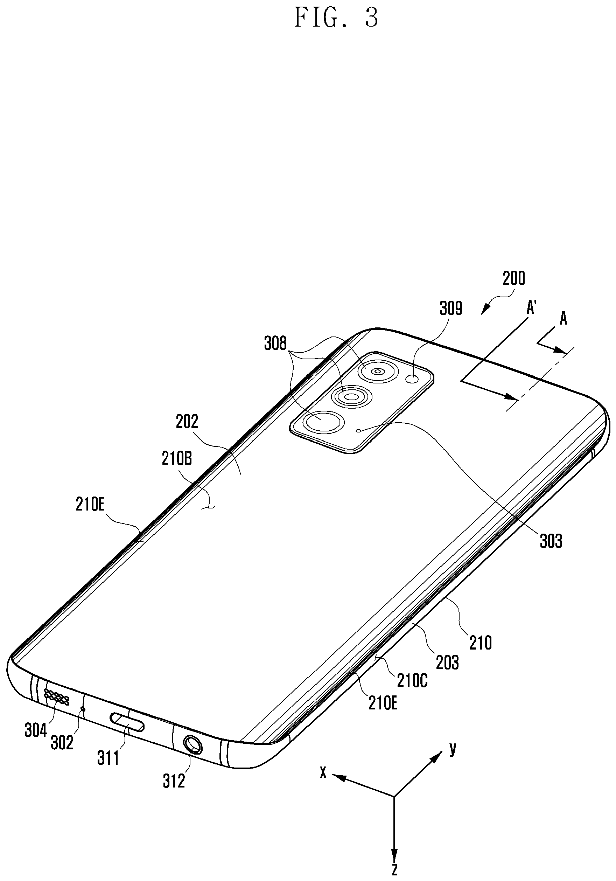

FIG. 2 is a perspective view of the front surface of an electronic device according to an embodiment. FIG. 3 is a perspective view of the rear surface of the electronic device of FIG. 2 according to an embodiment.

With reference to FIGS. 2 and 3, in an embodiment, the electronic device 200 (e.g., the electronic device 101 of FIG. 1) may include a housing 210 that includes the first surface (or the front surface) 210A, the second surface (or the rear surface) 210B, and the side surface 210C surrounding the space between the first surface 210A and the second surface 210B. In some embodiments, the housing 210 may refer to a structure that includes at least a portion of the first surface 210A, the second surface 210B, and the side surface 210C. The first surface 210A may be provided by at least a partially transparent front plate (or a first plate) 201 (e.g., a glass plate or a polymer plate including various coating layers). The second surface 210B may be provided by a substantially opaque rear plate (or a second plate) 202. The rear plate 202 may be provided, for example, by a coated or colored glass, a ceramic, a polymer, a metal (e.g., an aluminum, a stainless steel (STS), or a magnesium), or a combination of at least two of the above materials. The side surface 210C may be provided by a side bezel structure (or "lateral member") 203 coupled to the front plate 201 and the rear plate 202, and the side bezel structure 203 may include a metal and/or a polymer. In some embodiments, the rear plate 202 and the side bezel structure 203 may be formed integrally and may contain the same material (e.g., a metal material such as an aluminum).

In an embodiment, the front plate 201 may include two first areas 210D that are curved from the first surface 210A toward the rear plate 202 and extended seamlessly. The first areas 210D may be formed adjacent to each of both long edges of the front plate 201. The rear plate 202 may include two second areas 210E that are curved from the second surface 210B toward the front plate 201 and extended seamlessly. The second areas 210E may be formed adjacent to each of both long edges of the rear plate 202. The side surface 210C may have a first thickness (or width) (e.g., a height in the z-axis direction) on the side where the first areas 210D and the second areas 210E are not located, and it may have a second thickness smaller than the first thickness on the side where the first areas 210D and the second areas 210E are located. In some embodiments, the front plate 201 may be implemented including one of the first areas 210D or may be implemented without curved first areas 210D. In some embodiments, the rear plate 202 may be implemented including one of the second area 210E or may be implemented without curved second areas 210E.

According to an embodiment, the electronic device 200 may include at least one of a display 301, a first audio module 302, a second audio module 303, a third audio module 304, a fourth audio module 305, a sensor module 306, a first camera module 307, a plurality of second camera modules 308, a light-emitting module 309, an input module 310, a first connection terminal module 311, or a second connection terminal module 312. In some embodiments, the electronic device 200 may omit at least one of the components or additionally include other components.

The display area (e.g., the screen display area or the active area) of the display 301, for example, may be visually exposed through the front plate 201. In an embodiment, the electronic device 200 may be implemented to maximize the display area visible through the front plate 201 (e.g., a large screen or a full screen). For example, the display 301 may be implemented to have an outline of the same shape as the outline shape of the front plate 201. For another example, the spacing between the outlines of the display 301 and those of the front plate 201 may be roughly the same. In an embodiment, the display 301 may include a touch sensing circuit. In some embodiments, the display 301 may include a pressure sensor capable of measuring the intensity (pressure) of the touch. In some embodiments, the display 301 may be coupled to or located adjacent to a digitizer (e.g., an electromagnetic induction panel) that detects a magnetic field type electronic pen (e.g., a stylus pen).

The first audio module 302 may include, for example, a first microphone located inside the electronic device 200 and a first microphone hole provided on the side surface 210C corresponding to the first microphone. The second audio module 303 may include, for example, a second microphone located inside the electronic device 200 and a second microphone hole provided on the second surface 210B corresponding to the second microphone. The position or number of audio modules with respect to the microphone may vary without being limited to the illustrated examples. In some embodiments, the electronic device 200 may include a plurality of microphones used to sense the direction of sound.

The third audio module 304 may include, for example, a first speaker located inside the electronic device 200 and a first speaker hole provided on the side surface 210C corresponding to the first speaker. The fourth audio module 305 may include, for example, a second speaker located inside the electronic device 200 and a second speaker hole formed on the first surface 210A corresponding to the second speaker. In an embodiment, the first speaker may include an external speaker. In an embodiment, the second speaker may include a receiver for calling, and the second speaker hole may be referred to as a receiver hole. The position or number of the third audio module 304 or the fourth audio module 305 may vary without being limited to the illustrated examples. In some embodiments, the microphone hole and the speaker hole may be implemented as one hole. In some embodiments, the third audio module 304 or the fourth audio module 305 may include a piezo speaker with a speaker hole omitted.

The sensor module 306 may generate an electrical signal or data value corresponding to, for example, an internal operating state of the electronic device 200 or an external environmental state. In an embodiment, the sensor module 306 may include an optical sensor located inside the electronic device 200 corresponding to the first surface 210A. The optical sensor may include, for example, a proximity sensor or an illuminance sensor. The optical sensor may be aligned with the opening provided in the display 301. External light may enter the optical sensor through the opening of the front plate 201 and the display 301. In some embodiments, the optical sensor may be disposed at the bottom of the display 301 and may perform a related function without the position of the optical sensor being visually distinguished (or exposed). For example, the optical sensor may be located on the rear surface of the display 301 or below or beneath the display 301. In some embodiments, the optical sensor may be aligned and positioned on the recess provided on the rear of the display 301. The optical sensor may be overlapped with at least a portion of the screen so that it may perform a sensing function without being exposed to the outside. In this case, some areas of the optical sensor and at least some overlapping display 301 may include different pixel structures and/or wiring structures compared to other areas. For example, some areas of the optical sensor and at least some overlapping display 301 may have different pixel densities compared to other areas. In some embodiments, a plurality of pixels may not be disposed in some areas of the display 301 that at least partially overlaps with the optical sensor. In some embodiments, the electronic device 200 may include a biometric sensor (e.g., a fingerprint sensor) located below the display 301. Biosensors may be implemented by optical or ultrasonic methods, and their positions or numbers may vary. In some embodiments, the electronic device 200 may include a biometric sensor (e.g., a fingerprint sensor) located below the display 301. Biosensors may be implemented by optical or ultrasonic methods, and their positions or numbers may vary. The electronic device 200 may further include at least one of various other sensor modules, such as a gesture sensor, a gyro sensor, a barometric pressure sensor, a magnetic sensor, an acceleration sensor, a grip sensor, a color sensor, an IR (infrared) sensor, a temperature sensor, or a humidity sensor.

The first camera module 307 (e.g., the front camera module) may be located, for example, inside the electronic device 200 corresponding to the first surface 210A. A plurality of second camera modules 308 (e.g., the rear camera modules) may be located, for example, inside the electronic device 200 corresponding to the second surface 210B. The first camera module 307 and/or a plurality of second camera modules 308 may include one or more lenses, an image sensor, and/or an image signal processor. The position or number of the first camera module or the second camera module may vary without being limited to the illustrated examples.

According to an embodiment, the display 301 may include an opening aligned with the first camera module 307. The external light may reach the first camera module 307 through the opening of the front plate 201 and the display 301. In some embodiments, the opening of the display 301 may be formed in the form of a notch depending on the position of the first camera module 307. In some embodiments, the first camera module 307 may be disposed at the bottom of the display 301 and may perform a related function (e.g., an image shooting) without the position of the first camera module 307 being visually distinguished (or exposed). For example, the first camera module 307 may be located on the rear surface of the display 301 or below or beneath the display 301 and may include a hidden display rear camera (e.g., an under display camera (UDC)). In some embodiments, the first camera module 307 may be aligned and positioned on a recess formed on the rear surface of the display 301. The first camera module 307 may be overlapped with at least a portion of the screen to acquire an image of an external subject without being visually exposed to the outside. In this case, some areas of the first camera module 307 and at least some overlapping display 301 may include different pixel structures and/or wiring structures compared to other areas. For example, some areas of the first camera module 307 and at least some overlapping display 301 may have different pixel densities compared to other areas. The pixel structure and/or wiring structure formed in some areas of the first camera module 307 and at least some overlapping display 301 may reduce the loss of light between the external and the first camera module 307. In some embodiments, pixels may not be disposed in some areas of the first camera module 307 and at least some overlapping display 301. In some embodiments, the electronic device 200 may further include a light-emitting module (e.g., a light source) located inside the electronic device 200 corresponding to the first surface 210A. The light-emitting module may provide state information of the electronic device 200, for example, in an optical form. In some embodiments, the light-emitting module may provide a light source that is interlocked with the operation of the first camera module 307. The light-emitting module may include, for example, an LED, an IR LED, or a xenon lamp.

According to an embodiment, the plurality of second camera modules 308 may have different attributes (e.g., an angle of view) or functions and may include, for example, dual cameras or triple cameras. The plurality of second camera modules 308 may include a plurality of camera modules comprising lenses having different angles of view, and the electronic device 200 may control to change the angle of view of the camera module performed in the electronic device 200 based on the user's selection. The plurality of second camera modules 308 may include at least one of a wide-angle camera, a telephoto camera, a color camera, a monochrome camera, or an infrared (IR) camera (e.g., a time of flight (TOF) camera, a structured light camera). In some embodiments, the IR camera may operate as at least part of the sensor module. The light-emitting module 309 (e.g., a flash) may include a light source for a plurality of second camera modules 308. The light-emitting module 309 may include, for example, an LED or a xenon lamp.

The input module 310 may include, for example, one or more keystroke devices. One or more keystroke devices may be located, for example, in the opening provided on the side surface 210C. In some embodiments, the electronic device 200 may not include some or all of the keystroke devices, and the keystroke device not included may be implemented as a soft key using the display 301. The position or number of input modules 310 may vary, and in some embodiments, the input module 310 may include at least one sensor module.

The first connection terminal module (e.g., a first connector module or a first interface terminal module) 311 may include, for example, a first connector (or a first interface terminal) located inside the electronic device 200 and a first connector hole provided on the side surface 210C corresponding to the first connector. The second connection terminal module (e.g., a second connector module or a second interface terminal module) 312 may include, for example, a second connector (or a second interface terminal) located inside the electronic device 200 and a second connector hole provided on the side surface 210C corresponding to the second connector. The electronic device 200 may transmit and/or receive power and/or data to/from an external electronic device electrically connected to the first connector or the second connector. In an embodiment, the first connector may include a universal serial bus (USB) connector or a high definition multimedia interface (HDMI) connector. In an embodiment, the second connector may include an audio connector (e.g., a headphone connector or an earset connector). The position or number of connection terminal modules may vary without being limited to the illustrated examples.

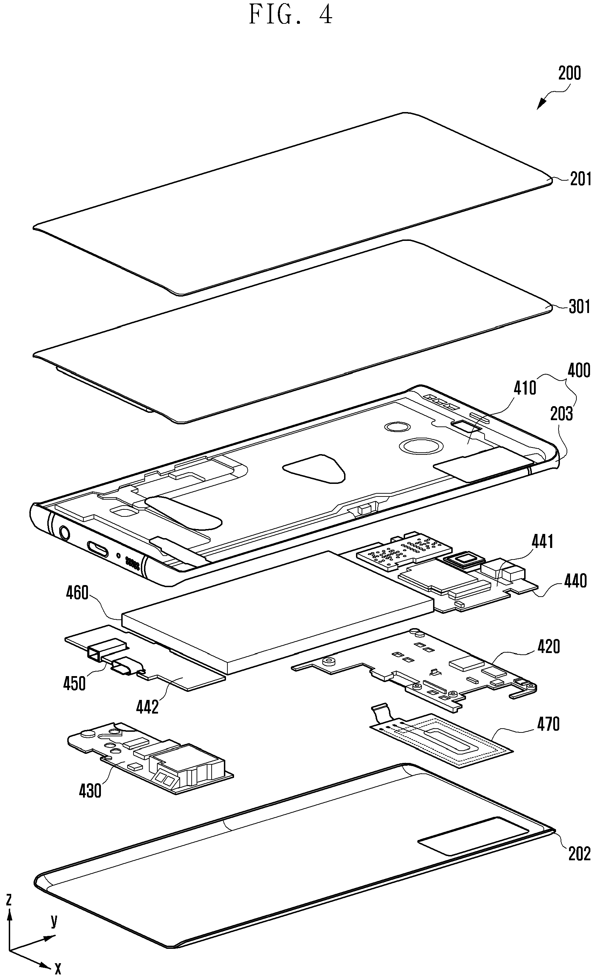

FIG. 4 is an exploded perspective view of the electronic device of FIG. 2 according to an embodiment.

With reference to FIG. 4, in an embodiment, the electronic device 200 may include a front plate 201, a rear plate 202, a side bezel structure 203, a first support member 410, a second support member 420, a third support member 430, a display 301, a first substrate assembly 440, a second substrate assembly 450, a battery 460, or an antenna structure 470. In some embodiments, the electronic device 200 may omit at least one of the components (e.g., a second support member 420 or a third support member 430) or additionally include other components.

The first support member 410 may be located, for example, inside the electronic device 200 and connected to the side bezel structure 203, or it may be integrally formed with the side bezel structure 203. The first supporting member 410 may be formed, for example, of a metal material and/or a non-metal material (e.g., a polymer). In an embodiment, the conductive portion included in the first supporting member 410 may serve as an electromagnetic shield for the display 301, the first substrate assembly 440, and/or the second substrate assembly 450. It may be referred to as a front case 400, including a first support member 410 and a side bezel structure 203. The first support member 410 may contribute to a durability or a rigidity (e.g., a torsional rigidity) of the electronic device as a portion of the front case 400 in which components such as the display 301, the first substrate assembly 440, the second substrate assembly 450, or the battery 460 are disposed. Hereinafter, the first support member 410 may be referred to as a support structure (e.g., a bracket or a mounting plate).

The display 301 may be located, for example, between the support structure 410 and the front plate 201, and it may be disposed on one surface of the support structure 410. The first substrate assembly 440 and the second substrate assembly 450 may be located, for example, between the support structure 410 and the rear plate 202, and it may be disposed on the other surface of the support structure 410. The battery 460 may be, for example, located between the support structure 410 and the rear plate 202, and it may be disposed in the support structure 410.

According to an embodiment, the first substrate assembly 440 may include a first printed circuit board 441 (e.g., a printed circuit board (PCB), or a printed circuit board assembly (PBA)). The first substrate assembly 440 may include various electronic components electrically connected to the first printed circuit board 441. The electronic components may be disposed on the first printed circuit board 441 or electrically connected to the first printed circuit board 441 through an electrical path such as a cable or a flexible printed circuit board (FPCB). With reference to FIGS. 2 and 3, the electronic components may include, for example, a second microphone included in the second audio module 303, a second speaker included in the fourth audio module 305, a sensor module 306, a first camera module 307, a plurality of second camera modules 308, a light-emitting module 309, or an input module 310.

According to an embodiment, the second substrate assembly 450 may be disposed apart from the first substrate assembly 440 with the battery 460 in between when viewed from the top of the front plate 201 (e.g., in the direction of the -z axis). The second substrate assembly 450 may include a second printed circuit board 451 electrically connected to the first printed circuit board 441 of the first substrate assembly 440. The second substrate assembly 450 may include various electronic components electrically connected to the second printed circuit board 451. The electronic components may be disposed on the second printed circuit board 451 or electrically connected to the second printed circuit board 451 via an electrical path such as a cable or FPCB. With reference to FIGS. 2 and 3, the electronic components may include, for example, a first microphone included in the first audio module 302, a first speaker included in the third audio module 304, a first connector included in the first connection terminal module 311, or a second connector included in the second connection terminal module 312.

According to some embodiments, the first substrate assembly 440 or the second substrate assembly 450 may include a primary PCB (or a main PCB or a master PCB), a secondary PCB (or a slave PCB) partially overlapped with the primary PCB, and/or an interposer substrate between the primary PCB and the secondary PCB.

The battery 460, as a device for supplying power to at least one component of the electronic device 200, may include, for example, a non-rechargeable primary cell, a rechargeable secondary cell, or a fuel cell. The battery 460 may be integrally disposed inside the electronic device 200 or may be detachably disposed with the electronic device 200.

According to an embodiment, the second support member 420 may be located between the support structure 410 and the rear plate 202 and may be coupled to the support structure 410 using a fastening element such as a bolt. At least a portion of the first substrate assembly 440 may be located between the support structure 410 and the second support member 420, and the second support member 420 may cover and protect the first substrate assembly 440. The third support member 430 may be located at least partially apart from the second support member 430 with the battery 460 in between when viewed from the top of the rear plate 202 (e.g., in the direction of the +z axis). The third support member 430 may be located between the support structure 410 and the rear plate 202 and may be coupled to the support structure 410 using a fastening element such as a bolt. At least a portion of the second substrate assembly 450 may be located between the support structure 410 and the third support member 430, and the third support member 430 may cover and protect the second substrate assembly 450. The second supporting member 420 and/or the third supporting member 430 may be formed of a metal material and/or a non-metal material (e.g., a polymer). In some embodiments, the second support member 420 may serve as an electromagnetic shield for the first substrate assembly 440, and the third support member 430 may serve as an electromagnetic shield for the second substrate assembly 450. In some embodiments, the second support member 420 and/or the third support member 430 may be referred to as a rear case.

According to some embodiments, an integrated substrate assembly including a first substrate assembly 440 and a second substrate assembly 450 may be implemented. For example, when viewed from the top of the rear plate 202 (e.g., in the direction of the +z axis), the substrate assembly may include first and second portions located apart from each other with the battery 460 in between, and a third portion extending between the battery 460 and the side bezel structure 203 and connecting the first and second portions. In this case, an integrated support member including a second support member 420 and a third support member 430 may be implemented.

According to an embodiment, the antenna structure 470 may be located between the second support member 420 and the rear plate 202. In some embodiments, the antenna structure 470 may be located between the battery 460 and the rear plate 202. The antenna structure 470 may be implemented in the form of a film, for example, a FPCB. The antenna structure 470 may include at least one conductive pattern utilized as a loop-type emitter. For example, the at least one conductive pattern may include a planar spiral conductive pattern (e.g., a planar coil, or a pattern coil). In an embodiment, at least one conductive pattern included in the antenna structure 470 may be electrically connected to a wireless communication circuit (or wireless communication module) included in the first substrate assembly 440. For example, at least one conductive pattern may be utilized for short-range wireless communication such as near field communication (NFC). For another example, at least one conductive pattern may be utilized for magnetic secure transmission (MST) for transmitting and/or receiving a magnetic signal. In some embodiments, at least one conductive pattern included in the antenna structure 470 may be electrically connected to the power transmission and reception circuit included in the first substrate assembly 440. The power transmission and reception circuit may wirelessly receive power from an external electronic device using at least one conductive pattern, or wirelessly transmit power to an external electronic device. The power transmission and reception circuit may include a power management module, for example, a power management integrated circuit (PMIC) or a charger integrated circuit (IC). The power transmission and reception circuit may charge the battery 460 using the power received wirelessly using a conductive pattern.

The electronic device 200 may further include various components depending on the form of its provision. These components vary in variation according to the convergence trend of the electronic device 200 and may not be enumerated all, but additional components equivalent to the above-mentioned components may be additionally included in the electronic device 200. In various embodiments, certain components may be excluded from the above components or replaced by other components, depending on the form of provision.

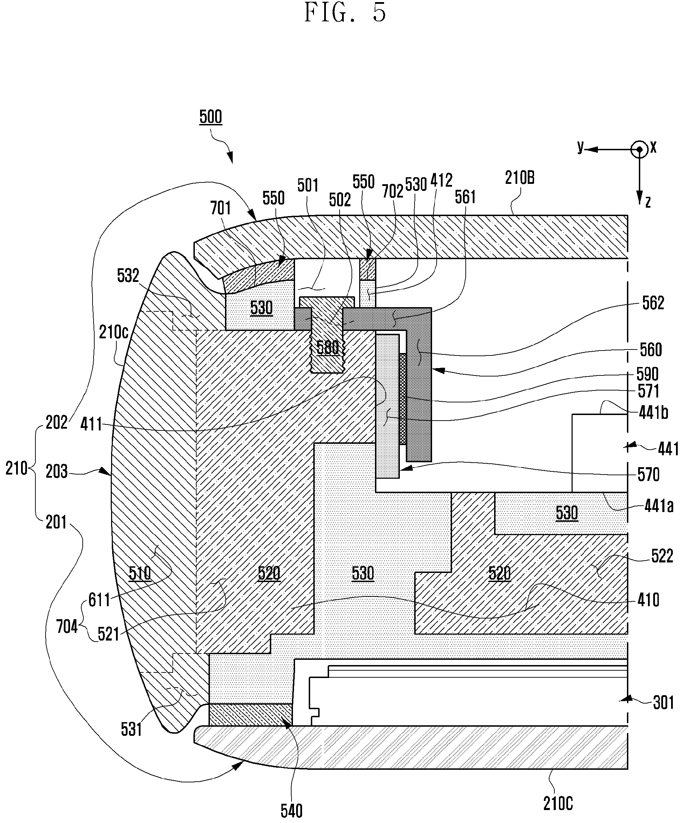

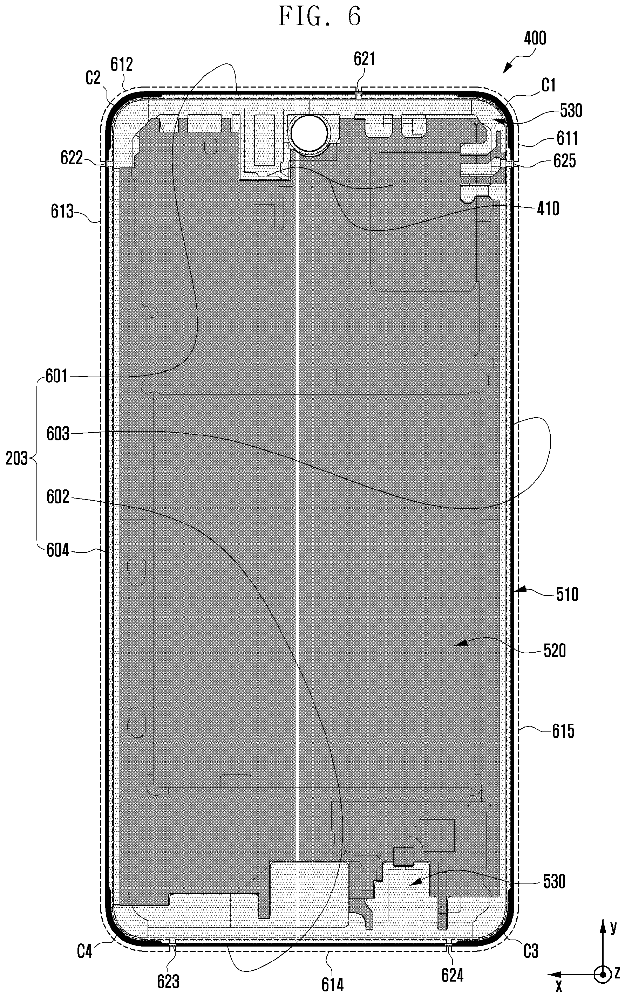

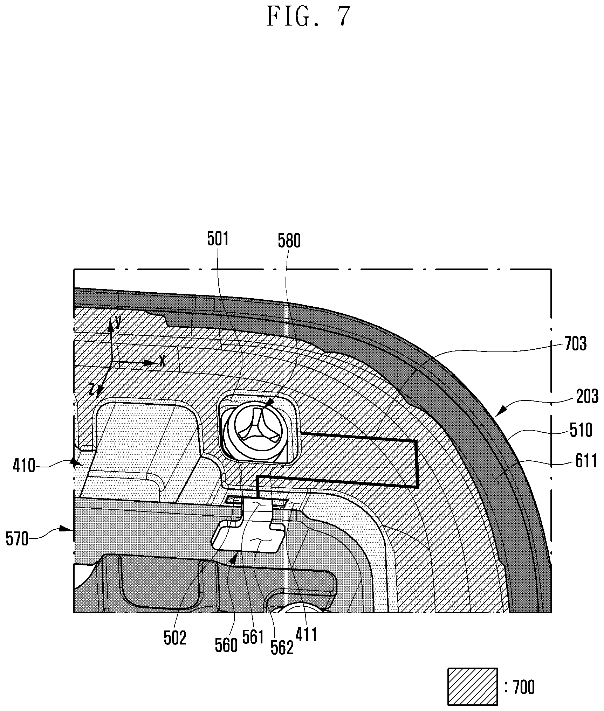

FIG. 5, in an embodiment, illustrates a cross-sectional structure 500 of the y-z plane with respect to the A-A' line in FIG. 3. FIG. 6, in an embodiment, is a plan view of the front case 400 of FIG. 4 when viewed in the +z axis direction. FIG. 7, in an embodiment, illustrates a side bezel structure 203, a support structure 410, a first electrical path 560, a second electrical path 570, or a bolt 580 in connection with the example of FIG. 5.

With reference to FIG. 5, in an embodiment, the cross-sectional structure 500 may include a housing 210, a display 301, a first printed circuit board 441, a support structure 410, a first adhesive member 540, a second adhesive member 550, a first electrical path 560, a second electrical path 570, or a bolt 580.

The housing 210 may include, for example, a front surface 210A of the electronic device 200 (refer to FIG. 2), a rear surface 210B of the electronic device 200, and a side surface 210C that surrounds at least a portion of the space between the front surface 210A and the rear surface 210B. The housing 210 may include a front plate 201, a rear plate 202, and a side bezel structure 203. The front plate 201 may form at least a portion of the front surface 210A. The rear plate 202 may form at least a portion of the rear surface 210B. The side bezel structure 203 may form at least a portion of the side surface 210C. The support structure 410 may be connected to the side bezel structure 203, may be integrated with the side bezel structure 203, or may be located in the space between the front plate 201 and the rear plate 202. The front case 400 (refer to FIG. 6), including the side bezel structure 203 and the support structure 410, may include, for example, a first bezel portion 601, a second bezel portion 602, a third bezel portion 603, or a fourth bezel portion 604. The first bezel portion 601 and the second bezel portion 602 may be spaced apart from each other and extended in parallel. The third bezel portion 603 may connect one end of the first bezel portion 601 and one end of the second bezel portion 602. The fourth bezel portion 604 may connect the other end of the first bezel portion 601 and the other end of the second bezel portion 602 and may be separated from the third bezel portion 603 and extended in parallel. The first corner portion C1 to which the first bezel portion 601 and the third bezel portion 603 are connected, the second corner portion C2 to which the first bezel portion 601 and the fourth bezel portion 604 are connected, the third corner portion C3 to which the second bezel portion 602 and the third bezel portion 603 are connected, and/or the fourth corner portion C4 to which the second bezel portion 602 and the fourth bezel portion 604 are connected, may be formed in a round shape. The first bezel portion 601 and the second bezel portion 602 may have a first length extending in the x-axis direction, and the third bezel portion 603 and the fourth bezel portion 604 may have a second length greater than the first length extending in the y-axis direction. In some embodiments, the first length and the second length may be formed substantially the same. The display 301 may be disposed in the support structure 410 between the support structure 410 and the front plate 201. The first printed circuit board 441 may be disposed in the support structure 410 between the support structure 410 and the rear plate 202.

With reference to FIGS. 5, 6, and 7, in an embodiment, the front case 400 may include an outer conductive structure 510, an inner conductive structure 520, and/or a non-conductive structure 530. The side bezel structure 203 may include an outer conductive structure 510. The outer conductive structure (or an outer metal structure or a first metal structure) 510 may include a first metal material and may form at least part of the side surface 210C. The support structure 410 may include the inner conductive structure 520. The inner conductive structure (or an inner metal structure or a second metal structure) 520 may be located in the space between the front plate 201 and the rear plate 202. The inner conductive structure 520 may serve as an electromagnetic shield for electronic components (e.g., a display 301, a first printed circuit board 441). For example, the inner conductive structure 520 may be electrically connected to the ground included in the first printed circuit board 441, and at least a portion of the inner conductive structure 520 may serve as an electromagnetic shielding structure (or a ground structure) to reduce the electromagnetic impact (e.g., an electromagnetic interference (EMI)) to the components included in the electronic device 200 (refer to FIG. 2). In an embodiment, a portion of the inner conductive structure 520 may serve as an electrical path between the components. The inner conductive structure 520 may include the same first metal material as the outer conductive structure 510. For example, the outer conductive structure 510 and the inner conductive structure 520 may be integrally formed. In some embodiments, the inner conductive structure 520 may include a second metal material that is different from the first metal material. The first metal material may include, for example, a titanium, an amorphous alloy, a metal-ceramic composite (e.g., cermet), or a stainless steel. The second metal material may include, for example, a magnesium, a magnesium alloy, an aluminum, an aluminum alloy, a zinc alloy, or a copper alloy. In some embodiments, the first metal material is a metal material different from the second metal material, for example, a magnesium, a magnesium alloy, an aluminum, an aluminum alloy, a zinc alloy, or a copper alloy. The first metal material or the second metal material may be various. The outer conductive structure 510 or the inner conductive structure 520 may be formed using various machining methods such as computer numerical control (CNC), die casting, or pressing. The non-conductive structure 530 may include a polymer and may be connected to the outer conductive structure 510 and the inner conductive structure 520. The support structure 410 may include at least a portion of the non-conductive structure 530. In some embodiments, the non-conductive structure 530 may include a first side rim 531 extending between the outer conductive structure 510 and the front plate 201 to form a portion of the side surface 210C. The first side rim 531 may be disposed in an annular shape along the edge of the front plate 201. The non-conductive structure 530 may include a second side rim 532 extending between the outer conductive structure 510 and the rear plate 202 to form a portion of the side surface 210C. The second side rim 532 may be disposed in an annular shape along the edge of the rear plate 202. In case that the non-conductive structure 530 includes a side rim (e.g., a first side rim 531 or a second side rim 532), the outer conductive structure 510 may be changed to a corresponding form. In case that the non-conductive structure 530 includes a first side rim 531 or a second side rim 532, the side bezel structure 203 may include a first side rim 531 or a second side rim 532. In some embodiments, the first side rim 531 and/or the second side rim 532 may be implemented as another non-conductive structure separated from the non-conductive structure 530 and may be disposed in the outer conductive structure 510. For example, a side rim separated from the non-conductive structure 530 (e.g., the first side rim 531 or the second side rim 532) may be formed in a form bonded to the outer conductive structure 510 using insert injection molding. For another example, a side rim separated from the non-conductive structure 530 may be formed separately and coupled to the outer conductive structure 510. In some embodiments, the first side rim 531 may be formed in a form bonded to the front plate 201 by insert injection molding, or it may be formed separately and coupled to the front plate 201. In some embodiments, the second side rim 532 may be formed in a form bonded to the rear plate 202 by insert injection molding, or it may be formed separately and coupled to the rear plate 202. Between the non-conductive structure (or the polymer structure) 530 and the outer conductive structure 510, and/or between the non-conductive structure 530 and the inner conductive structure 520, various polymer adhesive materials or sealants may be located. The non-conductive structure 530, for example, may include various polymers such as engineering plastic (e.g., polycarbonate (PC) or polymethyl methacrylate (PMMA)). For another example, the non-conductive structure 530 may include a material (e.g., fiber reinforced plastic (FRP)) in which the engineering plastic is mixed with various reinforcing substances such as a glass fiber or a carbon fiber. In an embodiment, the non-conductive structure 530 may include a polymer resin such as a polyether ether ketone, a polyphenylene sulfide, a polybutylene terephthalate, a polyimide, or a polycarbonate. The non-conductive structure 530 may be formed into a form coupled to the inner conductive structure 520 using insert molding.

According to some embodiments, a portion of the outer conductive structure 510 may extend into the space between the front plate 201 and the rear plate 202 and form a portion of the support structure 410.

According to an embodiment, the front plate 201 may be coupled to the support structure 410 using the first adhesive member 540. The first adhesive member 540 may be located between the support structure 410 and the front plate 201 along the side bezel structure 203. The first adhesive member 540 may be disposed in an annular shape adjacent to the edge of the front plate 201. The first adhesive member 540 may prevent external foreign substances such as water or dust from entering the space between the front plate 201 and the support structure 410 through the front plate 201 and the side bezel structure 203. The rear plate 202 may be coupled to the support structure 410 using a second adhesive member 550. The second adhesive member 550 may be located between the support structure 410 and the rear plate 202 along the side bezel structure 203. The second adhesive member 550 may be disposed in an annular shape adjacent to the edge of the rear plate 202. The second adhesive member 550 may prevent external foreign substances such as water or dust from entering the space between the rear plate 202 and the support structure 410 through the rear plate 202 and the side bezel structure 203. The first adhesive member 540 or the second adhesive member 550 may include, for example, a thermal reaction adhesive material, a photoreaction adhesive material, a general adhesive, or a double-sided tape.

The electronic device 200 (refer to FIG. 2) may include, for example, at least one antenna and a wireless communication circuit electrically connected to the at least one antenna (e.g., the wireless communication module 192 of FIG. 1). The wireless communication circuit may be disposed on the first printed circuit board 441. The antenna may include, for example, at least one antenna emitter, ground, or transmission line. At least one antenna emitter may be connected to a wireless communication circuit to form an electromagnetic field capable of transmitting and/or receiving a signal of at least one frequency in a selected or specified frequency band. At least one antenna emitter may include a conductive pattern located or included in the housing 210, or a conductive pattern (e.g., a laser direct structuring (LDS) form, a flexible printed circuit board (FPCB) form, or a form implemented by plating or printing, or a microscript located on the first printed circuit board 441). The wireless communication circuit may process a transmission signal or a reception signal in at least one specified frequency band through at least one antenna emitter. The designated frequency band may include, for example, at least one of a low band (LB) (about 600 MHz ~ about 1 GHz), a middle band (MB) (about 1 GHz ~ about 2.3 GHz), a high band (HB) (about 2.3 GHz ~ about 2.7 GHz), or an ultra-high band (UHB) (about 2.7 GHz ~ about 6 GHz). The designated frequency band may include a variety of other frequency bands. The transmission line may electrically connect a wireless communication circuit and at least one antenna emitter and transmit a signal (voltage, current) of a radio frequency (RF). The transmission line may include, for example, an electrical path implemented by various forms of conductive structures or wiring connecting a wireless communication circuit and at least one antenna emitter. The ground (or antenna ground) may include, for example, a ground (e.g., a ground plane) located or included in the first printed circuit board 441. The antenna may include a frequency regulation circuit (e.g., a matching circuit) connected to a transmission line between at least one antenna emitter and a wireless communication circuit. The frequency regulation circuit may include an electrical device having components such as an inductance, a capacitance, or a conductance acting on the transmission line.

The outer conductive structure 510 (refer to FIG. 6) may include, for example, a first conductive portion 611, a second conductive portion 612, a third conductive portion 613, a fourth conductive portion 614, and a fifth conductive part 615 that are physically separated from each other by being disposed on the non-conductive structure 530. The non-conductive structure 530 (refer to FIG. 6) may include a first insulating portion 621 extending to a segmentation portion between the first conductive portion 611 and the second conductive portion 612, a second insulating portion 622 extending to a segmentation portion between the second conductive portion 612 and the third conductive portion 613, a third insulating portion 623 extending to a segmentation portion between the third conductive portion 613 and the fourth conductive portion 614, a fourth insulating portion 624 extending to the segmentation portion between the fourth conductive portion 614 and the fifth conductive portion 615, and a fifth insulating portion 625 extending to a segmentation portion between the fifth conductive portion 615 and the first conductive portion 611. The first insulating portion 621, the second insulating portion 622, the third insulating portion 623, the fourth insulating portion 624, and the fifth insulating portion 625 may be included in the side bezel structure 203 and may form a part of the side surface 210C (refer to FIG. 2). The form or number of conductive parts included in the outer conductive structure 510 may vary without being limited to the illustrated examples. In an embodiment, at least a portion of the outer conductive structure 510 may be electrically connected to a wireless communication circuit (e.g., the wireless communication module 192 of FIG. 1) and operate as an antenna emitter. In an embodiment, at least a portion of the outer conductive structure 510 (e.g., the first conductive portion 611, the second conductive portion 612, the third conductive portion 613, the fourth conductive portion 614, or the fifth conductive portion 615) may be utilized as an antenna emitter.

According to an embodiment, the first electrical path 560 may include a first portion 561 extending into the interior of the support structure 410, and a second portion 562 extending from the first portion 561 and electrically connected to the second electrical path 570. In an embodiment, the inner conductive structure 520 may include a first conductive area 521 connected to or integrally formed with the outer conductive structure 510 (in the illustrated example, the first conductive portion 611) and a second conductive area 522 that is physically separated from the first conductive area 521. In some embodiments, the first conductive area 521 may be referred to as an element included in the outer conductive structure 510. The first portion 561 of the first electrical path 560 may be electrically connected to the first conductive area 521 of the inner conductive structure 520 at a position overlapped (or aligned) with the first opening (e.g., hole 501) of the support structure 410. The first portion 561 and the first conductive area 521 may overlap in alignment with the first opening 501 when viewed from the top of the rear plate 202 (e.g., in the direction of the +z axis). The first opening 501 may be located between the first conductive area 521 and the rear plate 202. A portion of the first portion 561 may be exposed through the first opening 501, and the first portion 561 and the first conductive area 521 may be mechanically connected using the bolt 580 in the first opening 501. The support structure 410 may include a second opening 502 that communicates with the first opening 501. The first portion 561 of the first electrical path 560 may be located at the second opening 502 and may be at least partially located inside the support structure 410. The second opening 502 may include an insertion space in the carved form and may include, for example, a groove, a recess, or a slit. A portion of the first portion 561 extending into the interior of the support structure 410 may be electrically and mechanically connected to the first conductive area 521 of the inner conductive structure 520 using a bolt 580 at the first opening 501. A portion 571 (hereinafter, the third portion) of the second electrical path 570 may be located between the second portion 562 of the first electrical path 560 and the surface of the support structure 410. The area 411 facing the third portion 571 of the surface of the support structure 410 may support the second portion 562 and the third portion 571, and it may hereinafter be referred to as the support area. The support area 411 may be formed not parallel to one surface 441a of the first printed circuit board 441 facing the front surface 210A of the electronic device 200 or the other surface 441b of the first printed circuit board 441 facing the rear surface 210B of the electronic device 200. In an embodiment, the support area 411 may be substantially perpendicular to one surface 441a or the other surface 441b of the first printed circuit board 441. The support area 411 may include, for example, a plane facing the second bezel portion 602 of FIG. 6. In an embodiment, the first portion 561 and the second portion 662 of the first electrical path 560 may be disposed in a substantially flat form and may be perpendicular to each other. In various embodiments, the support area 411 may be formed as a plane directed in various different directions at a right angle to one surface 441a or the other surface 441b of the first printed circuit board 441. In some embodiments, the support area 411 may be formed at an obtuse angle to one surface 441a or the other surface 441b of the first printed circuit board 441. In some embodiments, the support area 411 may include a curved surface. In some embodiments, adhesive materials of various polymers may be located between the support area 411 of the support structure 410 and the third portion 571 of the second electrical path 570.

According to an embodiment, a portion 412 (hereinafter, the fourth portion) of the support structure 410 may be located between the second adhesive member 550 and the first portion 561 of the first electrical path 560. The second adhesive member 550 may be disposed in the first adhesive area 701 and the second adhesive area 702 of the support structure 410. The second adhesive area 702 may be provided by the fourth portion 412. The first adhesive area 701 may be provided by a different portion of the support structure 410 from the fourth portion 412. As a comparative example, in the case that the first portion 561 is not extended to the interior of the support structure 410, the second adhesive area 702 may not be formed, and the adhesive area 700 for bonding durability between the support structure 410 and the rear plate 202 may be difficult to secure. The case that the first portion 561 is not extended to the interior of the support structure 410, for example, may include the case that the first portion 561 is disposed on the surface of the support structure 410, or the case that the fourth portion 412 is omitted by placing the first electrical path 560 on the recess formed in the support structure 410. FIGS. 5 and 7 present the first portion 561 in a form to easily describe the technical contents of the embodiment and to facilitate understanding of the embodiment, but it may be more difficult to secure the adhesive area 700 in the case that the first portion 561 is expanded to various other forms such as drawing code '703' (refer to FIG. 7) and is not extended to the interior of the support structure 410. In the case that the bonding durability between the support structure 410 and the rear plate 202 is not secured, an external impact (e.g., an impact because of the fall of the electronic device 200) may cause a gap between the support structure 410 and the rear plate 202 and the waterproof function may be degraded because the external foreign substances such as water or dust may move into the gap.

In various embodiments, the first adhesive area 701 and/or the second adhesive area 702 may be provided by the non-conductive structure 530, but not limited thereto, and may be provided by the inner conductive structure 520.

According to an embodiment, the first electrical path 560 may be implemented as a substantially rigid or hard conductor. The first electrical path 560 may include, for example, any metal plate including the first portion 561 and the second portion 562. When the first portion 561 is electrically and mechanically connected to the first conductive area 521 of the inner conductive structure 520 using the bolt 580, the third portion 571 of the second electrical path 570 may be pressurized by the second portion 562 and may be pressed close to the support area 411 of the support structure 410. The second opening 502 may serve as a guide for facilitating the placement of the first electrical path 560 in the support structure 410, contributing to assembly. In an embodiment, the second electrical path 570 may include a flexible printed circuit board (FPCB). In some embodiments, the second electrical path 570 may include a rigid-flexible printed circuit board (RFPCB). The second portion 562 of the first electrical path 560 and the third portion 571 of the second electrical path 570 may be physically contacted and electrically connected. In some embodiments, a conductive adhesive material 590 may be located between the second portion 562 and the third portion 571. The conductive adhesive material 590 may include, for example, at least one of a solder, a copper, a silver paste, an aluminum, a silver-aluminum, a carbon paster, or a carbon nanotube (CNT) paste. For example, the second portion 562 and the third portion 571 may be electrically and mechanically connected using surface mounting technology (SMT). In some embodiments, a flexible conductive member may be located between the second portion 562 and the third portion 571. The flexible conductive member may be various, such as a conductive clip (e.g., a conductive member including an elastic structure), a pogo pin, a spring, a conductive poron, a conductive rubber, a conductive tape, or a conductive connector. In some embodiments, the first portion 561 of the first electrical path 560 may be located between the support area 411 of the support structure 410 and the third portion 571 of the second electrical path 570. The first electrical path 560 may be electrically connected to the first printed circuit board 441 via the second electrical path 570. Although not shown, the third electrical path (e.g., the metal plate) may extend into the interior of the support structure 410 in substantially the same manner as the first electrical path 560 and may be electrically connected to the first conductive area 521 of the inner conductive structure 520. The third electrical path may be electrically connected to the second electrical path 570 in substantially the same manner as the energizing structure between the first electrical path 560 and the second electrical path 570. The wireless communication circuit (e.g., the wireless communication module 192 of FIG. 1) disposed on the first printed circuit board 441 may transmit and receive signals to/from the first electrical path 560 through the second electrical path 570. The first electrical path 560 may be, for example, an emitter (or antenna emitter) 704 including the first conductive portion 611 of the outer conductive structure 510 and the first conductive area 521 of the inner conductive structure 520. The emitter (or antenna emitter) 704 may be electrically connected to the ground of the electronic device 200 (e.g., the second ground included in the second electrical path 570 and the first ground included in the first printed circuit board 441) through a third electrical path. When the wireless communication circuit supplies emitted current to the power feed unit, the emitter 704 may form a signal path between the power feed unit and the ground. In an embodiment, the first portion 561 of the first electrical path 560 may contribute to forming an electrical path (e.g., the length expressed as a ratio of wavelengths) corresponding to the selected or specified resonant frequency. In some embodiments, a frequency regulation circuit (e.g., a tuner or a passive device) having components such as an inductance, a capacitance, or a conductance acting on the transmission line may be disposed on the second electrical path 570.

According to some embodiments, it may be implemented as an integrated rigid-flexible printed circuit board by replacing the first electrical path 560 and the second electrical path 570. For example, a portion of the rigid-flexible printed circuit board may be located inside the support structure 410 through the second opening 502 and may be substantially rigid.

According to some embodiments, although not shown, an energizing structure according to the example of FIG. 5 may be applied to the second conductive portion 612, the third conductive portion 613, the fourth conductive portion 614, or the fifth conductive portion 615 of the outer conductive structure 510.

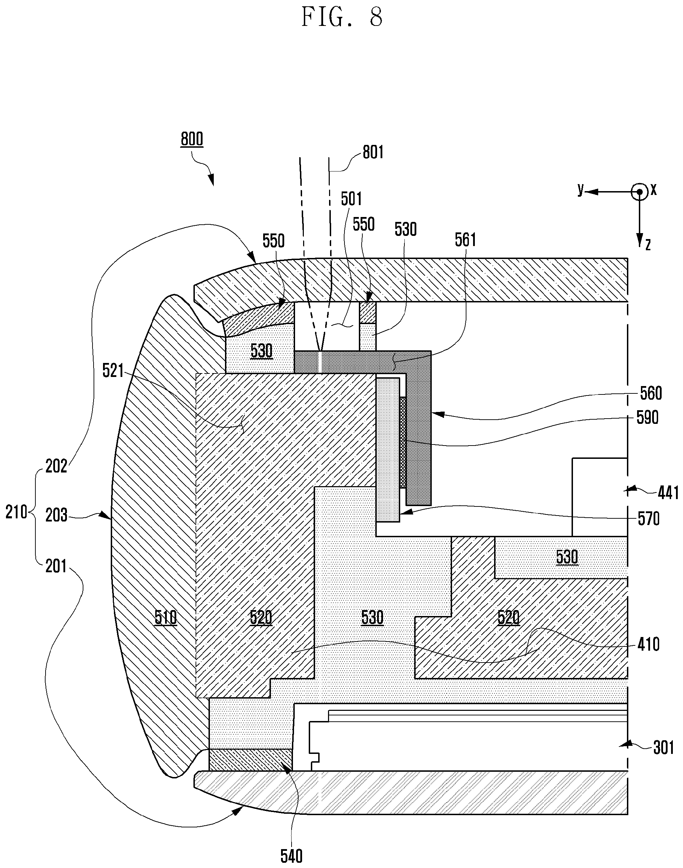

FIG. 8, in another embodiment, illustrates a cross-sectional structure 800 of the y-z plane with respect to the A-A' line in FIG. 3.

With reference to FIG. 8, in an embodiment, the first portion 561 of the first electrical path 560 (e.g., a metal plate) and the first conductive area 521 of the inner conductive structure 520 may be electrically connected using welding at a position overlapped (or aligned) with the first opening 501. For example, the welding device 801 may apply heat to the first portion 561 of the first electrical path 560 at the first opening 501, and the boundary between the first portion 561 of the first electrical path 560 and the first conductive area 521 of the inner conductive structure 520 may be melted and combined. In some embodiments, a conductive adhesive material (not shown) may be located between the first portion 561 of the first electrical path 560 and the first conductive area 521 of the inner conductive structure 520. The conductive adhesive material may include, for example, a thermally reactive conductive adhesive material, and may be melt-bonded to the first portion 561 of the first electrical path 560 and the first conductive area 521 of the inner conductive structure 520 when welded. The conductive adhesive material may contribute to increasing the interfacial bonding with the first portion 561 between the first portion 561 of the first electrical path 560 and the first conductive area 521 of the inner conductive structure 520. The conductive adhesive material may have a lower melting point than the metal material included in the first portion 561 and the metal material included in the first conductive area 521.

According to some embodiments, the first portion 561 of the first electrical path 560 and the first conductive area 521 of the inner conductive structure 520 may be electrically and mechanically connected using ultrasonic welding. When ultrasonic vibration is applied, the first portion 561 and the first conductive area 521 may be electrically and mechanically connected by frictional heat between the first portion 561 and the first conductive area 521. In this case, the support structure 410 may be implemented without a first opening 501, thereby expanding the adhesive area of the support structure 410 for disposing the second adhesive member 550. For example, the non-conductive structure 530 may be implemented without a first opening 501.

According to some embodiments, a conductive adhesive material may be located between the first portion 561 of the first electrical path 560 and the first conductive area 521 of the inner conductive structure 520. The conductive adhesive material may include, for example, at least one of a solder, a copper, a silver paste, an aluminum, a silver-aluminum, a carbon paste, or a CNT paste. In this case, the support structure 410 may be implemented without an opening 501, thereby expanding the adhesive area of the support structure 410 for disposing the second adhesive member 550.

According to some embodiments, a flexible conductive member such as a pogo pin, a spring, a conductive poron, a conductive rubber, a conductive tape, or a conductive connector may be located between the first portion 561 of the first electrical path 560 and the first conductive area 521 of the inner conductive structure 520. In this case, the support structure 410 may be implemented without a first opening 501, thereby expanding the adhesive area of the support structure 410 for disposing the second adhesive member 550.

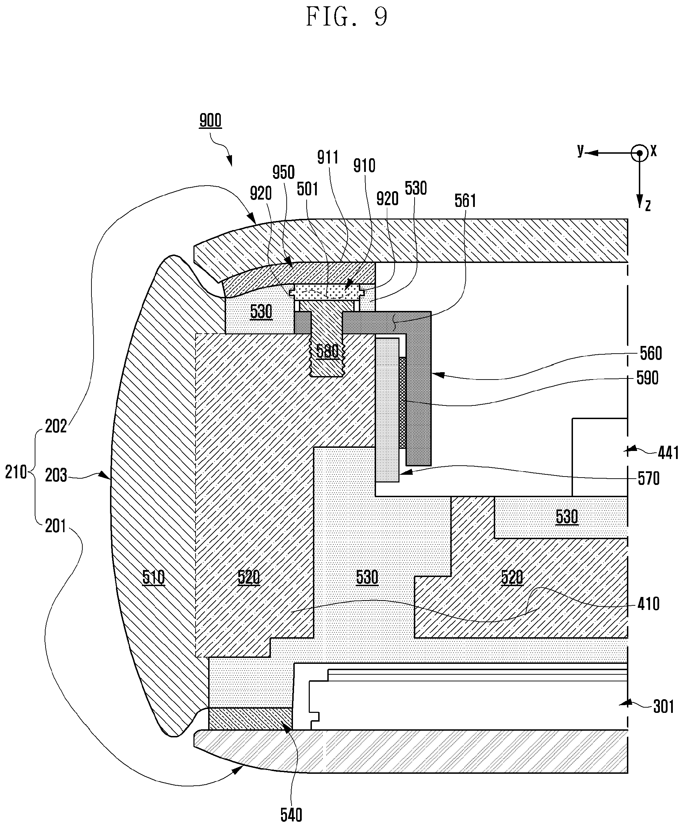

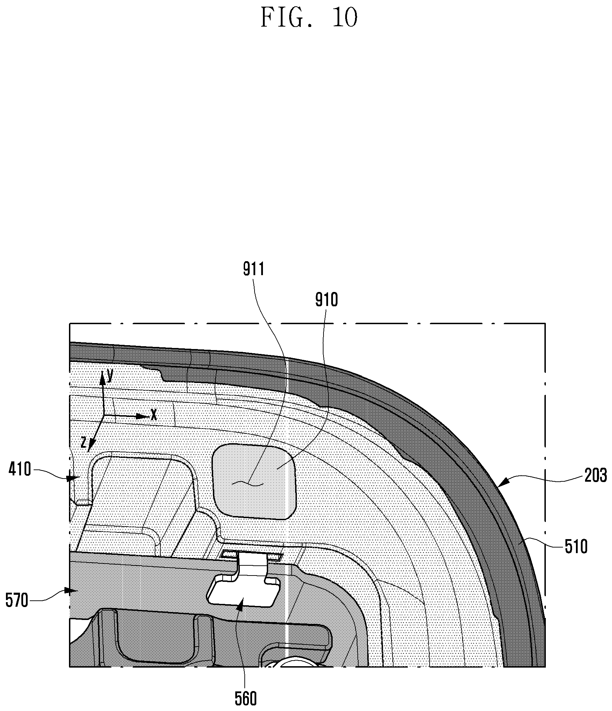

FIG. 9, in another embodiment, illustrates a cross-sectional structure 900 of the y-z plane with respect to the A-A' line in FIG. 3. FIG. 10, for example, in connection with the example of FIG. 9, illustrates a side bezel structure 203, a support structure 410, a first electrical path 560, a second electrical path 570, or a cover member 910.

FIG. 9 relates to another embodiment that alters or modifies the example of FIG. 5 and, for example, some components having the same drawing code as the drawing code of FIG. 5, or some components having a different drawing code, but having the same term as the drawing code of FIG. 5 may be modified according to the embodiment of FIG. 9.

With reference to FIGS. 9 and 10, in an embodiment, the cover member 910 may be located at the first opening 501. The second adhesive member 950 may be extended to the adhesive area 911 formed by the cover member 910 compared to the second adhesive member 550 according to the example of FIG. 5. The cover member 910 may be formed by solidifying after filling with a liquid or paste-like sealant or adhesive material such as a curing in place of gas (CIPG) in the first opening 501. In some embodiments, the cover member 910 may include a thermal reaction material or a photoreactive material.

According to some embodiments, the cover member 910 may include an elastic member or a flexible member, such as a rubber elastically coupled to the first opening 501.

According to some embodiments, the cover member 910 may be coupled with the support structure 410 in various interweaving structures 920, such as a dovetail joint, in the first opening 501. The interweaving structure 920 may contribute so that the cover member 910 is not separated from the first opening 501 of the support structure 410. In the interweaving structure 920, for example, the cover member 910 may include a protrusion (e.g., a fastener such as a hook), and the first opening 501 of the support structure 410 may include a form corresponding to the protrusion of the cover member 910 (e.g., an undercut structure).

According to some embodiments, the cover member 910 may not be visually distinguishable from the support structure 410. For example, the cover member 910 may contain the same material as the non-conductive structure 530 forming the first opening 501, and the surface of the cover member 910 and the surface of the non-conductive structure 530 may be smoothly connected. For another example, a coating layer covering the support structure 410 and the cover member 910 may be added, so that the position of the cover member 910 may not be visually distinguished.

According to various embodiments, in the example of FIG. 8, a cover member may be located in the first opening 501. In this case, the cover member 910 of FIG. 8 may be extended to an adhesive area formed by the cover member.

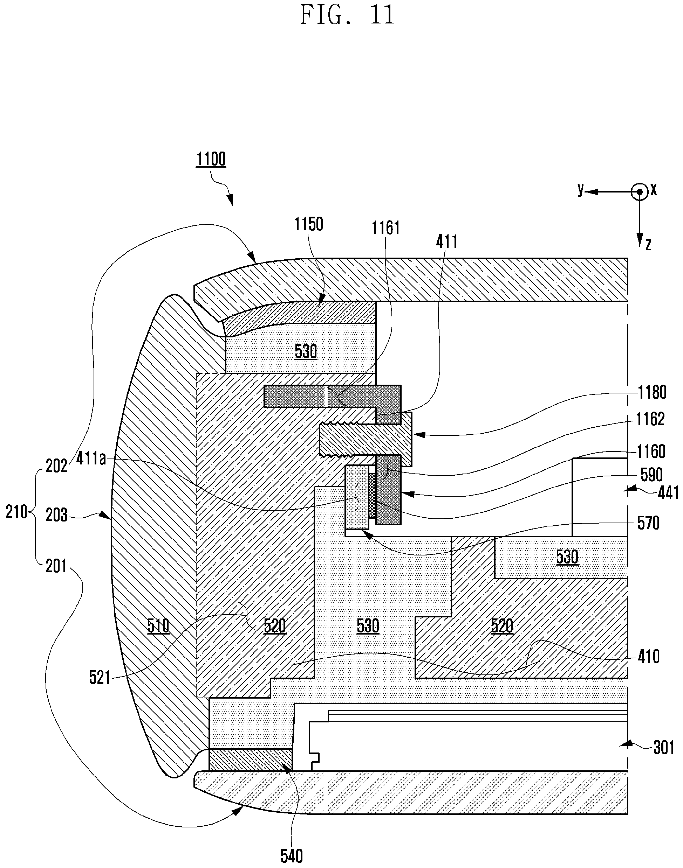

FIG. 11, in another embodiment, illustrates the cross-sectional structure 1100 of the y-z plane with respect to the A-A' line in FIG. 3.

FIG. 11 relates to another embodiment that alters or modifies the example of FIG. 5 and, for example, some components having the same drawing code as the drawing code of FIG. 5, or some components having a different drawing code, but having the same term as the drawing code of FIG. 5 may be modified according to the embodiment of FIG. 11.

With reference to FIG. 11, the first portion 1161 of the first electrical path 1160 (e.g., a metal plate) may be located inside the support structure 410. The second portion 1162 of the first electrical path 1160 may be electrically and mechanically connected to the first conductive area 521 of the inner conductive structure 520 using a bolt 1180 in the support area 411 of the support structure 410. In some embodiments, the second portion 1162 may be electrically and mechanically connected to the first conductive area 521 using welding. In some embodiments, instead of bolting, a conductive adhesive material may be located between the second portion 1162 and the first conductive area 521. In some embodiments, an oxidation layer of a non-conductive material may be formed on the surface of the inner conductive structure 520 using anodic oxidation or anodizing. The oxidation layer of the non-conductive material may be applied to the surface of the inner conductive structure 520 by passing an electric current through an electrolyte solution (e.g., a sulfuric acid solution or a nitric acid solution). The oxidation layer of the non-conductive material, for example, may increase the surface strength or prevent corrosion of the inner conductive structure 520 as a coating layer for protecting the inner conductive structure 520 from the outside. In this case, a portion of the oxidation layer of the non-conductive material may be removed corresponding to the second portion 1162 of the first electrical path 1160 of the first conductive area 521 of the inner conductive structure 520. According to various embodiments, in the example of FIG. 5, the surface of the first conductive area 521 facing the first portion 561 of the first electrical path 560 using the bolt 580 may not contain an oxidizing layer of the non-conductive material because of anodizing. In the example of FIG. 11, the support structure 410 may be formed without a first opening 501 and the adhesive area of the support structure 410 for disposing the second adhesive member 1150 may be extended compared to the example of FIG. 5. The support area 411 may be implemented in the form of including a recess 411a for accommodating a second electrical path 570 (e.g., a flexible printed circuit board) between the support area 411 and the second portion 1162.

According to an embodiment, the first portion 1161 of the first electrical path 1160 may be electrically connected to the support structure 410 through at least some physical contact. In some embodiments, a conductive material (e.g., a conductive adhesive material) may be located between the first portion 1161 and the support structure 410. In some embodiments, a non-conductive material (e.g., a non-conductive adhesive material) may be located between the first portion 1161 and the support structure 410 and the first portion 1161 and the support structure 410 may be physically separated.

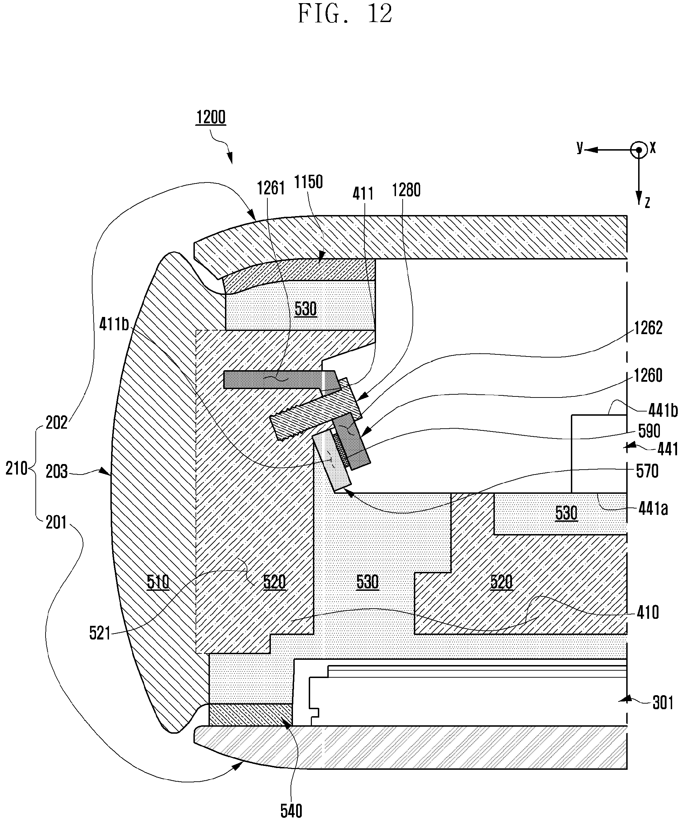

FIG. 12, in another embodiment, illustrates a cross-sectional structure 1200 of the y-z plane with respect to the line A-A'in FIG. 3.

FIG. 12 relates to another embodiment that alters or modifies the example of FIG. 11, for example, some components having the same drawing code as the drawing code of FIG. 11, or some components having a different drawing code, but having the same term as the drawing code of FIG. 11 may be modified according to the embodiment of FIG. 12.

With reference to FIG. 12, the first portion 1261 of the first electrical path 1260 (e.g., a metal plate) may be located inside the support structure 410. The second portion 1262 of the first electrical path 1260 may be electrically and mechanically connected to the first conductive area 521 of the inner conductive structure 520 using the bolt 1280 at the support area 411 of the support structure 410. In an embodiment, the support area 411 may include an inclined surface at an angle to one surface 441a or the other surface 441b of the first printed circuit board 441 compared to the example of FIG. 11. The second portion 1262 of the first electrical path 1260 may extend from the first portion 1261 corresponding to the slope. For example, the first portion 1261 and the second portion 1262 of the first electrical path 1260 may be substantially flat and may form an obtuse angle to each other. The inclined surface may be formed in the form of including a recess 411b for accommodating a second electrical path 570 (e.g., a flexible printed circuit board) between the support area 411 and the second portion 1162.

According to an embodiment of the present document, an electronic device (e.g., the electronic device 200 of FIG. 2) may include a housing (e.g., the housing 210 of FIG. 5). The housing may include a front plate (e.g., the front plate 201 of FIG. 5), a rear plate (e.g., the rear plate 202 of FIG. 5), and a side bezel structure (e.g., the side bezel structure 203 of FIG. 5) that surrounds at least part of the space between the front plate and the rear plate. The electronic device may include a support structure (e.g., the support structure 410 of FIG. 5) located in the space. The support structure may be connected to the side bezel structure or integrated with the side bezel structure. The electronic device may include an electrical path (e.g., the first electrical path 560 of FIG. 5). The electrical path may include a first portion extending into the interior of the support structure (e.g., the first portion 561 of FIG. 5) and a second portion extending from the first portion to the space (e.g., the second portion 562 of FIG. 5). The electrical path may be electrically connected to a conductive portion (e.g., the outer conductive structure 510 of FIG. 5) included in the side bezel structure. The electronic device may include a first adhesive member (e.g., the first adhesive member 540 of FIG. 5) located between the support structure and the front plate along the side bezel structure. The electronic device may include a second adhesive member (e.g., the second adhesive member 550 of FIG. 5) located between the support structure and the rear plate along the side bezel structure. A portion of the support structure (e.g., the fourth portion 412 of FIG. 5) may be located between the second adhesive member and the first portion.

According to an embodiment of the present document, the electrical path (e.g., the first electrical path 560 of FIG. 5) may include a metal plate.

According to an embodiment of the present document, the electrical path may further include a flexible printed circuit board (e.g., the second electrical path 570 of FIG. 5) electrically connected to the metal plate.

According to an embodiment of the present document, a portion of the flexible printed circuit board (e.g., the third portion 571 of FIG. 5) is located between the second portion (e.g., the second portion 562 of FIG. 5) and the support structure (e.g., the support structure 410 of FIG. 5) and may be electrically connected to the second portion.

According to an embodiment of the present document, the electrical path (e.g., the first electrical path 560 of FIG. 5) may be electrically connected to the conductive portion (e.g., the outer conductive structure 510 of FIG. 5) through the first portion (e.g., the first portion 561 of FIG. 5).

According to an embodiment of the present document, the support structure (e.g., the support structure 410 of FIG. 5) may include the conductive area (e.g., the first conductive area 521 of FIG. 5) connected to or integrally formed with the conductive portion (e.g., the outer conductive structure 510 of FIG. 5). The first portion (e.g., the first portion 561 of FIG. 5) and the conductive area may be electrically connected at a position overlapping with the opening (e.g., the first opening 501 of FIG. 5) formed in the support structure. The opening may be located between the conductive area and the rear plate (e.g., the rear plate 202 of FIG. 5).

According to an embodiment of the present document, the first portion (e.g., the first portion 561 of FIG. 5) and the first conductive area (e.g., the first conductive area 521 of FIG. 5) may be electrically connected using a bolt (e.g., the bolt 580 of FIG. 5) at a position overlapped with the opening (e.g., the first opening 501 of FIG. 5).

According to an embodiment of the present document, the first portion (e.g., the first portion 561 of FIG. 5) and the first conductive area (e.g., the first conductive area 521 of FIG. 5) may be electrically connected using welding at a position overlapping with the opening (e.g., the first opening 501 of FIG. 5).

According to an embodiment of the present document, the electronic device (e.g., the electronic device 200 of FIG. 2) may further include a cover member (e.g., the cover member 910 of FIG. 9) located at the opening (e.g., the first opening 501 of FIG. 5).

According to an embodiment of the present document, a portion of the second adhesive member (e.g., the second adhesive member 950 of FIG. 9) may be located between the cover member (e.g., the cover member 910 of FIG. 9) and the rear plate (e.g., the rear plate 202 of FIG. 9).

According to an embodiment of the present document, the support structure (e.g., the support structure 410 of FIG. 11) may include the conductive area (e.g., the first conductive area 521 of FIG. 11) connected to or integrally formed with the conductive portion (e.g., the outer conductive structure 510 of FIG. 11). The second portion (e.g., the second portion 1162 of FIG. 11) and the conductive area may be electrically and mechanically connected.

According to an embodiment of the present document, the second portion (e.g., the second portion 1162 of FIG. 11) and the conductive area (e.g., the first conductive area 521 of FIG. 11) may be electrically and mechanically connected using bolts (e.g., the bolt 1180 of FIG. 11).

According to an embodiment of the present document, the first portion (e.g., the first portion 561 of FIG. 5) and the second portion (e.g., the second portion 562 of FIG. 5) are flat and may be perpendicular to each other.

According to another embodiment of the present document, the first portion (e.g., the first portion 1261 of FIG. 12) and the second portion (e.g., the second portion 1262 of FIG. 12) may be flat and may form an obtuse angle to each other.

According to an embodiment of the present document, the electronic device (e.g., the electronic device 200 of FIG. 2) may further include a wireless communication circuit (e.g., the wireless communication module 192 of FIG. 1) electrically connected to the electrical path (e.g., the first electrical path 560 and the second electrical path 570 of FIG. 5).

According to an embodiment of this document, an electronic device (e.g., the electronic device 200 of FIG. 2) may include a housing (e.g., the housing 210 of FIG. 5). The housing may include a front plate (e.g., the front plate 201 of FIG. 5), a rear plate (e.g., the rear plate 202 of FIG. 5), and a side bezel structure (e.g., the side bezel structure 203 of FIG. 5) that surrounds at least part of the space between the front plate and the rear plate. The electronic device may include a support structure (e.g., the support structure 410 of FIG. 5) located in the space. The support structure may be connected to the side bezel structure or integrated with the side bezel structure. The electronic device may include a metal plate electrically connected to a conductive portion (e.g., the outer conductive structure 510 of FIG. 5) included in the side bezel structure (e.g., the first electrical path 560 of FIG. 5). The metal plate may include a first portion extending into the interior of the support structure (e.g., the first portion 561 of FIG. 5) and a second portion extending from the first portion to the space (e.g., the second portion 562 of FIG. 5). The electronic device may include a flexible printed circuit board (e.g., the second electrical path 570 of FIG. 5) electrically connected to the metal plate. The electronic device may include a first adhesive member (e.g., the first adhesive member 540 of FIG. 5) located between the support structure and the front plate along the side bezel structure. The electronic device may include a second adhesive member (e.g., the second adhesive member 550 of FIG. 5) located between the support structure and the rear plate along the side bezel structure. A portion of the support structure (e.g., the fourth portion 412 of FIG. 5) may be located between the second adhesive member and the first portion.

According to an embodiment of the present document, the support structure (e.g., the support structure 410 of FIG. 5) may include the conductive area (e.g., the first conductive area 521 of FIG. 5) connected to or integrally formed with the conductive portion (e.g., the outer conductive structure 510 of FIG. 5). The first portion and the conductive area may be electrically connected at a position overlapping with an opening (e.g., the first opening 501 of FIG. 5) formed in the support structure. The opening may be located between the conductive area and the rear plate (e.g., the rear plate 202 of FIG. 5).

According to an embodiment of the present document, the electronic device (e.g., the electronic device 200 of FIG. 2) may further include a cover member (e.g., the cover member 910 of FIG. 9) located in the opening (e.g., the first opening 501 of FIG. 9). A portion of the second adhesive member (e.g., the second adhesive member 950 of FIG. 9) may be located between the cover member (e.g., the cover member 910 of FIG. 9) and the rear plate (e.g., the rear plate 202 of FIG. 9).

According to an embodiment of the present document, a portion (e.g., the third portion 571 of FIG. 5) of the flexible printed circuit board (e.g., the second electrical path 570 of FIG. 5) may be located between the second portion (e.g., the second portion 562 of FIG. 5) and the support structure (e.g., the support structure 410 of FIG. 5) and may be electrically connected to the second portion.

According to an embodiment of the present document, the electronic device (e.g., the electronic device 200 of FIG. 2) may further include a wireless communication circuit (e.g., the wireless communication module 192 of FIG. 1) electrically connected to the flexible printed circuit board (e.g., the second electrical path 570 of FIG. 5).

The embodiments disclosed in the present document and drawings are merely specific examples to easily explain the technical contents and to facilitate the understanding of the embodiments, and are not intended to limit the scope of the embodiments. Therefore, the scope of the various embodiments of the present document should be construed as including all altered or modified forms in addition to the embodiments disclosed herein as defined by the appended claims.

## Claims

1. An electronic device (200) comprising:
a housing (210) including a front plate (210A), a rear plate (210B), and a side bezel structure (210C) which at least partially surrounds a space between the front plate (210A) and the rear plate (210B) and comprises a conductive portion (611);
a support structure (410) that is connected to the side bezel structure (210C) or is formed integrally with the side bezel structure (210C), and is located in the space;
a conductor (560) which includes a first portion (561) extending into the support structure (410) and a second portion (562) extending from the first portion (561) into the space;
a first adhesive member (540) located between the support structure (410) and the front plate (210A) along the side bezel structure (210C); and
a second adhesive member (550) located between the support structure (410) and the rear plate (210B) along the side bezel structure (210C), wherein
a portion of the support structure (410) is located between the second adhesive member (550) and the first portion (561),
**characterized in that** the support structure (410) comprises a conductive area (521), which is connected to or integrally formed with the conductive portion (611) of the side bezel structure (210C), and an opening (501) located between the conductive area (521)
and the rear plate (210B), and
wherein the first portion (561) of the conductor (560) and the conductive area (521) of the support structure (410) are electrically connected at a position overlapping the opening (501) such that the first portion (561) is electrically connected to the conductive portion (611) of the side bezel structure (203) through the conductive area (521) of the support structure (410).

2. The electronic device of claim 1, wherein the conductor (560) comprises a metal plate.

3. The electronic device of claim 2, further comprising a flexible printed circuit board electrically connected to the conductor (560).

4. The electronic device of claim 3, wherein a portion of the flexible printed circuit board is located between the second portion (562) of the conductor (560) and the support structure (410) and is electrically connected to the second portion (562) of the conductor (560).

5. The electronic device of claim 1, wherein the first portion (561) of the conductor (560) and the conductive area (521) of the support structure (410) are electrically connected using bolts (580) at the position overlapping with the opening (501).

6. The electronic device of claim 5, wherein the first portion (561) of the conductor (560) and the conductive area (521) of the support structure (410) are electrically connected using welding at the position overlapping with the opening (501).

7. The electronic device of claim 1, further comprising a cover member (910) located in the opening (501).

8. The electronic device of claim 7, wherein a portion of the second adhesive member (550) is located between the cover member (910) and the rear plate (210B).

9. The electronic device of claim 1, wherein the first portion (561) of the conductor (560) and the second portion (562) of the support structure (410) are flat and form a right angle to each other.

10. The electronic device of claim 1, wherein the first portion (561) of the conductor (560) and the second portion (562) of the support structure (410) are flat and form an obtuse angle to each other.

11. The electronic device of claim 1, further comprising a wireless communication circuit (192) electrically connected to the conductor (560).

## Patentansprüche

1. Elektronische Vorrichtung (200), umfassend:
ein Gehäuse (210), das eine Frontplatte (210A), eine Rückplatte (210B) und eine Seitenblendenstruktur (210C) beinhaltet, die zumindest teilweise einen Raum zwischen der Frontplatte (210A) und der Rückplatte (210B) umgibt und einen leitfähigen Abschnitt (611) umfasst;
eine Stützstruktur (410), die mit der Seitenblendenstruktur (210C) verbunden ist oder
einstückig mit der Seitenblendenstruktur (210C) ausgebildet ist und sich in dem Raum befindet;
einen Leiter (560), der einen ersten Abschnitt (561), der sich in die Stützstruktur (410) erstreckt, und einen zweiten Abschnitt (562), der sich von dem ersten Abschnitt (561) in den Raum erstreckt, beinhaltet;
ein erstes Haftelement (540), das sich zwischen der Stützstruktur (410) und der Frontplatte (210A) entlang der Seitenblendenstruktur (210C) befindet; und
ein zweites Haftelement (550), das sich zwischen der Stützstruktur (410) und der Rückplatte (210B) entlang der Seitenblendenstruktur (210C) befindet, wobei sich ein Abschnitt der Stützstruktur (410) zwischen dem zweiten Haftelement (550) und dem ersten Abschnitt (561) befindet,
**dadurch gekennzeichnet, dass** die Stützstruktur (410) einen leitfähigen Bereich (521), der mit dem leitfähigen Abschnitt (611) der Seitenblendenstruktur (210C) verbunden oder einstückig damit ausgebildet ist,
und eine Öffnung (501), die sich zwischen dem leitfähigen Bereich (521)
und der Rückplatte (210B) befindet, umfasst, und
wobei der erste Abschnitt (561) des Leiters (560) und der leitfähige Bereich (521) der Stützstruktur (410) an einer Position, die die Öffnung (501) überlappt, elektrisch verbunden sind, sodass der erste Abschnitt (561) durch den leitfähigen Bereich (521) der Stützstruktur (410) elektrisch mit dem leitfähigen Abschnitt (611) der Seitenblendenstruktur (203) verbunden ist.

2. Elektronische Vorrichtung nach Anspruch 1, wobei der Leiter (560) eine Metallplatte umfasst.

3. Elektronische Vorrichtung nach Anspruch 2, ferner umfassend eine flexible Leiterplatte, die elektrisch mit dem Leiter (560) verbunden ist.

4. Elektronische Vorrichtung nach Anspruch 3, wobei sich ein Abschnitt der flexiblen Leiterplatte zwischen dem zweiten Abschnitt (562) des Leiters (560) und der Stützstruktur (410) befindet und elektrisch mit dem zweiten Abschnitt (562) des Leiters (560) verbunden ist.

5. Elektronische Vorrichtung nach Anspruch 1, wobei der erste Abschnitt (561) des Leiters (560) und der leitfähige Bereich (521) der Stützstruktur (410) unter Verwendung von Schrauben (580) an der Position, die mit der Öffnung (501) überlappt, elektrisch verbunden sind.

6. Elektronische Vorrichtung nach Anspruch 5, wobei der erste Abschnitt (561) des Leiters (560) und der leitfähige Bereich (521) der Stützstruktur (410) unter Verwendung einer Schweißung an der Position, die mit der Öffnung (501) überlappt, elektrisch verbunden sind.

7. Elektronische Einrichtung nach Anspruch 1, ferner umfassend ein Abdeckelement (910), das sich in der Öffnung (501) befindet.

8. Elektronische Vorrichtung nach Anspruch 7, wobei sich ein Abschnitt des zweiten Haftelements (550) zwischen dem Abdeckelement (910) und der Rückplatte (210B) befindet.

9. Elektronische Vorrichtung nach Anspruch 1, wobei der erste Abschnitt (561) des Leiters (560) und der zweite Abschnitt (562) der Stützstruktur (410) flach sind und einen rechten Winkel zueinander bilden.

10. Elektronische Vorrichtung nach Anspruch 1, wobei der erste Abschnitt (561) des Leiters (560) und der zweite Abschnitt (562) der Stützstruktur (410) flach sind und einen stumpfen Winkel zueinander bilden.

11. Elektronische Vorrichtung nach Anspruch 1, ferner umfassend eine drahtlose Kommunikationsschaltung (192), die elektrisch mit dem Leiter (560) verbunden ist.

## Revendications

1. Dispositif électronique (200) comprenant :
un boîtier (210) comprenant une plaque avant (210A), une plaque arrière (210B) et une structure de cadre latéral (210C) qui entoure au moins en partie un espace entre la plaque avant (210A) et la plaque arrière (210B) et qui comprend une partie conductrice (611) ;
une structure de support (410) qui est reliée à la structure de cadre latéral (210C) ou qui est formée d'un seul tenant avec la structure de cadre latéral (210C) et qui est située dans l'espace ;
un conducteur (560) qui comprend une première partie (561) s'étendant dans la structure de support (410) et une seconde partie (562) s'étendant depuis la première partie (561) dans l'espace ;
un premier élément adhésif (540) situé entre la structure de support (410) et la plaque avant (210A) le long de la structure de cadre latéral (210C) ; et
un second élément adhésif (550) situé entre la structure de support (410) et la plaque arrière (210B) le long de la structure de cadre latéral (210C),
une partie de ladite structure de support (410) étant située entre ledit second élément adhésif (550) et ladite première partie (561),
**caractérisé en ce que** la structure de support (410) comprend une zone conductrice (521) qui est connectée à la partie conductrice (611) de la structure de cadre latéral (210C) ou qui est formée d'un seul tenant avec celle-ci, et une ouverture (501) située entre la zone conductrice (521) et la plaque arrière (210B), et
ladite première partie (561) du conducteur (560) et
ladite zone conductrice (521) de la structure de support (410) étant connectées électriquement au niveau d'une position chevauchant l'ouverture (501), de sorte que la première partie (561) soit connectée électriquement à la partie conductrice (611) de la structure de cadre latéral (203) par l'intermédiaire de la zone conductrice (521) de la structure de support (410).

2. Dispositif électronique selon la revendication 1, ledit conducteur (560) comprenant une plaque métallique.

3. Dispositif électronique selon la revendication 2, comprenant en outre une carte de circuit imprimé souple connectée électriquement au conducteur (560).

4. Dispositif électronique selon la revendication 3, une partie de la carte de circuit imprimé souple étant située entre la seconde partie (562) du conducteur (560) et la structure de support (410) et étant connectée électriquement à la seconde partie (562) du conducteur (560).

5. Dispositif électronique selon la revendication 1, la première partie (561) du conducteur (560) et la zone conductrice (521) de la structure de support (410) étant connectées électriquement au moyen de boulons (580) au niveau de la position chevauchant l'ouverture (501).

6. Dispositif électronique selon la revendication 5, la première partie (561) du conducteur (560) et la zone conductrice (521) de la structure de support (410) étant connectées électriquement par soudage au niveau de la position chevauchant l'ouverture (501).

7. Dispositif électronique selon la revendication 1, comprenant en outre un élément couvercle (910) situé dans l'ouverture (501).

8. Dispositif électronique selon la revendication 7, une partie du second élément adhésif (550) étant située entre l'élément couvercle (910) et la plaque arrière (210B).

9. Dispositif électronique selon la revendication 1, ladite première partie (561) du conducteur (560) et ladite seconde partie (562) de la structure de support (410) étant plates et formant un angle droit l'une par rapport à l'autre.

10. Dispositif électronique selon la revendication 1, ladite première partie (561) du conducteur (560) et ladite seconde partie (562) de la structure de support (410) étant plates et formant un angle obtus l'une par rapport à l'autre.

11. Dispositif électronique selon la revendication 1, comprenant en outre un circuit de communication sans fil (192) connecté électriquement au conducteur (560).
